# EUROPEAN PATENT APPLICATION

(11) **EP 2 532 972 A1**
(43) Date of publication of application: **12.12.2012**
(21) Application number: 12169281.8
(22) Date of filing: 24.05.2012
(51) Int. Cl.: F24C 7/08, H03K 17/96

(54) **An electronic home appliance**

(30) Priority: 10.06.2011 TR 201105722
(71) Applicant: Vestel Beyaz Esya Sanayi ve Ticaret A.S., 45030 Manisa (TR)
(72) Inventor: Tumba, Yesim, 45030 Manisa (TR)
(74) Representative: Cayli, Hülya

(57) **Abstract**

A home appliance of the present invention, which comprises at least one control panel (P) comprising at least one touch surface (1), and at least one control card (K) sensing and performing determined functions via said panel and comprising various electronic components, comprises at least one capacitive sensor (4) which comprises at least one elastic filling element (4b) and at least one metal strip (4a) coated around the filling element (4b), which is positioned on said card (K), and which senses the touch when touched on the touch surface (1). Therefore labor cost and an increase in the production time are prevented which are occurred due to the fact that sensors in the state of the art cannot be placed on the card (K) by the automatic placement machine.

## Description

### Technical Field

The present invention relates to electronic home appliances comprising at least one control card.

### Prior Art

In electronic home appliances comprising at least one control card such as a cooking device, control cards are provided for arranging operation of said home appliance. Said control cards comprise various electronic components such as resistor, transistor, etc. Said home appliances can comprise control panel connected to the control card for controlling the operation of the appliance by the users. The home appliance can be adjusted via dial buttons provided on the control panel as well as touching on the panel surface. In order to control the home appliance with touch, various components sensing touch are provided in the control cards. Said components can be an optic, capacitive, inductive or piezoelectric sensor.

The patent document no EP1344983A2 of the state of the art discloses arrangement of a control unit of a cooker. The control unit comprises a sensor for sensing heating zone on which a pan is placed, a touch control button for determining temperature level of the heating zones, a main control button, and an indicator for showing temperature level. In said control unit of the patent document, IR type touch buttons are provided.

A published patent document no EP0990855B1 of the state of the art discloses a control unit for a cooking device. Said control unit comprises at least one timer, touch buttons for controlling timer, and at least one display element for indicating the digits on the timer. A capacitive sensor can be used for the touch button provided in said control unit. However, said capacitive sensor cannot be placed on the card via automatic placement machines, and causes time and labour losses.

### Brief Description of the Invention

A home appliance of the present invention, which comprises at least one control panel comprising at least one touch surface, and at least one control card sensing and performing determined functions via said panel and comprising various electronic components, comprises at least one capacitive sensor which is positioned on said card, which senses the touch when there is a touch on the touch surface, and which comprises at least one elastic filling element and at least one metal strip coated around the filling element. Therefore labor cost and an increase in the production time are prevented which are occurred due to the fact that sensors in the state of the art cannot be placed on the card by the automatic placement machine.

### Objectives of the Invention

An aim of the invention is to develop an electronic home appliance comprising at least one capacitive sensor in the control card.

The other aim of the invention is to develop an electronic home appliance in which the capacitive sensor is placed on the control card via automatic placement machines.

Another aim of the invention is to develop an electronic home appliance comprising a cost effective and reliable capacitive sensor which is easy to produce and assemble.

### Description of the Drawings

Exemplary embodiments of the electronic home appliance comprising capacitive sensor of the present invention are shown in attached drawings wherein;
Figure 1 is a top view of the home appliance.
Figure 2 is a top view of the control card having a capacitive sensor thereon.
Figure 3 is a side sectional view of the capacitive sensor.

The parts in figures are individually enumerated and the corresponding terms of reference numbers are given as follows:

| | |
|---|---|
| Heating compartment | (B) |
| Control panel | (P) |
| Control card | (K) |
| Touch surface | (1) |
| Indicator surface | (2) |
| Indicator | (3) |
| Capacitive sensor | (4) |
| Metal strip | (4a) |
| Elastic filling element | (4b) |

### Description of the Invention

In electronic home appliances such as oven and stove, the operation of the appliance is adjusted via a control panel provided in the appliance. Said control panel is connected with a control card which is provided in the appliance and which comprises various electronic components for adjusting the operation of the appliance, and when necessary adjustments are made via push, dial and/or touch buttons provided on the panel, said adjustments are sensed via the control card. Thus, the user can operate the appliance in an adjustment which is desired by the user and meets the requirement. During the production process of the control card, the components provided on the card are preferably placed by the automatic placement devices. However, in the control cards connected to a control panel comprising particularly a touch button, the sensors sensing touch cannot be placed on the card via automatic placement machines, and generally at least one worker should place the sensor manually on the card and solder it. Said situation increases labour cost and leads to extension in the production process.

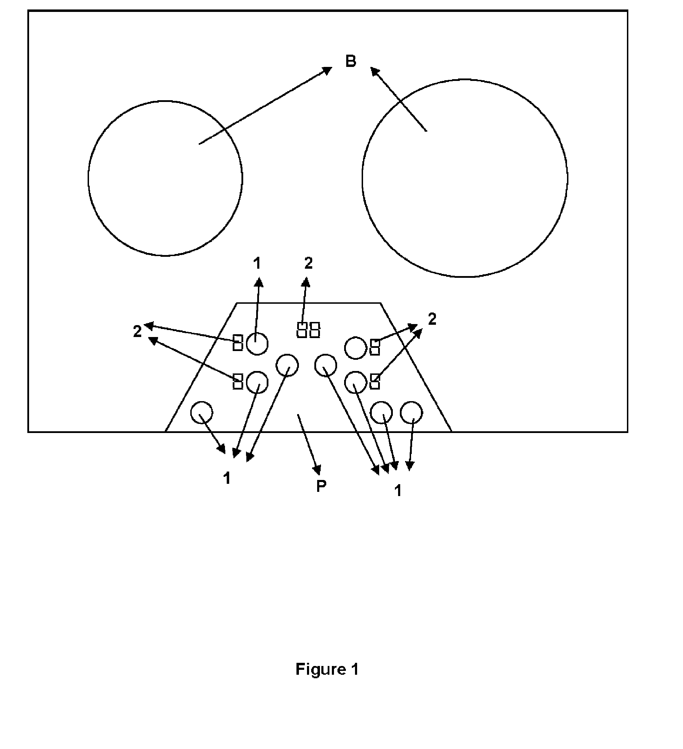

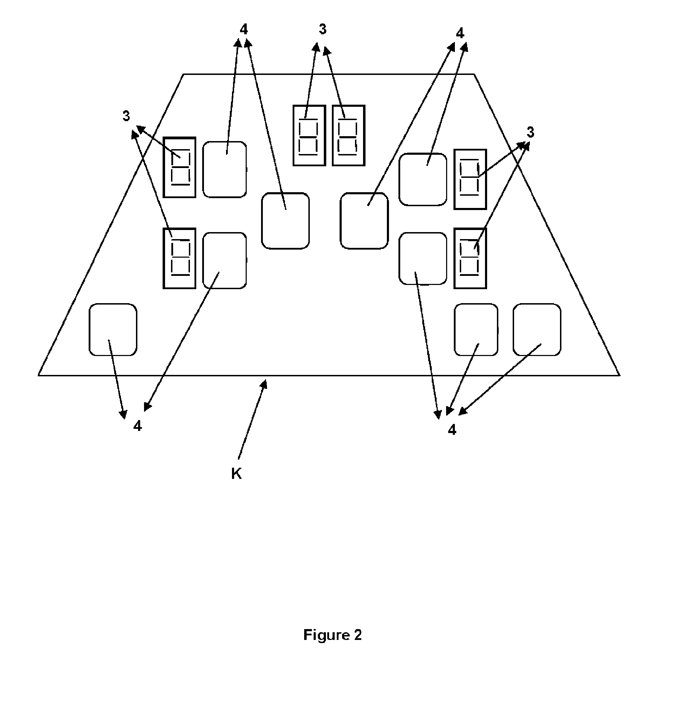

The present invention discloses a home appliance which is exemplified as an electronic cooking device and whose top view is shown in figure 1. Said home appliance comprises at least one control panel (P) by which operation status of the appliance is adjusted and at least one control card (K) (shown in figure 2) which senses and performs the functions determined via the panel (P), and which comprises various electronic components. The control panel (P), an exemplary view of which is shown in figure 1, comprises at least one touch surface (1). When the user, for example, desires to use a heating compartment (B) of the cooking device, he/she is able to activate the compartment (B) and make the temperature adjustment of the compartment (B) by touching the touch surface (1), which activates the related heating compartment (B).

The control panel (P), an exemplary view of which is shown in figure 1, is connected to the control card (K), an exemplary view of which is shown in figure 2. The control card (K) comprises at least one capacitive sensor (4) which senses the touch when the touch surface (1) in the panel (P) is touched. Therefore, desired operation adjustments of the home appliance are able to be applied by the touch of the user on the touch surface (1). As mentioned in the example above, when the user touches the touch surface (1) in the home appliance exemplified as a cooking device for activating for example a heating compartment (B) and/or for adjusting the temperature of the activated compartment (B), said condition is sensed by the capacitive sensor (4), and required functions are performed. Said sensor (4) is placed on the control card (K) preferably so as to be in the same alignment with the touch surface (1).

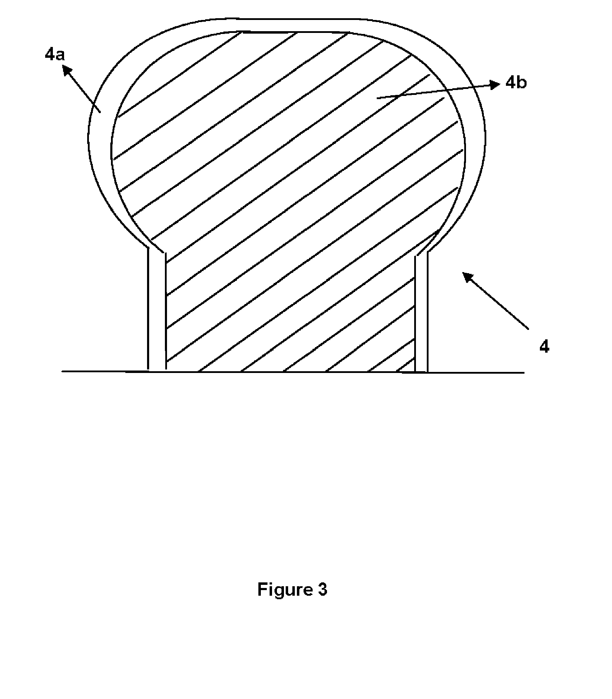

An exemplary view of the capacitive sensor (4), which is provided in the home appliance of the present invention, is shown in figure 3. The capacitive sensor (4) comprises at least one elastic filling element (4b) and at least one metal strip (4a) coated around the elastic filling element (4b). The capacitive sensor (4) is obtained by coating the metal strip (4a) on the elastic filling element (4b) and then by cutting the filling element (4b) coated with the metal strip (4a) in desired sizes for usage purpose. The capacitive sensor (4) produced in this way is able to be positioned on the control card (K) via the automatic placement machines; and is able to be fixed to the card (K) since the metal strip (4a) can be soldered easily. Therefore, the labor cost and production time decrease.

When the metal strip (4a) coated around the filling element (4b) is energized, the elastic filling element (4b), which can be preferably sponge, rubber or spring material, is statically charged and ensures formation of a static magnetic field in the capacitive sensor (4). Said filling element (4b) gives a smooth form to the capacitive sensor (4) and allows the magnetic field formed in the capacitive sensor (4) to affect up to the surface of the control panel (P). Therefore, when a foreign object is inserted in the static magnetic field formed in the capacitive sensor (4) (for example when the user closes his/her finger to the touch surface (1) on the panel (P)) over the panel (P), a change in the dielectric level occurs. Thanks to the change in the dielectric level, sensing process is performed via the change of oscillation frequency in the sensor circuit elements. Thus, the operation of the capacitive sensor (4) is ensured.

In a preferred embodiment of the invention, the home appliance can comprise at least one indicator surface (2), which is placed in said control panel (P), for indicating determined and/or performed appliance adjustment and/or operation status of the appliance to the user. Said indicator surface (2) is preferably in a transparent form. Also, said home appliance can comprise at least one audible alarm element which warns the user about the operation status of the appliance.

In another preferred embodiment of the invention, the home appliance can comprise at least one indicator (3), which is positioned on said control card (K), for indicating the operation status of the appliance and/or appliance adjustment, which has been made, on the indicator surface (2) provided on the panel (P). For example, temperature value of the selected compartment (B) is reflected on the indicator surface (2) by the indicator (3) and thanks to the transparent form of the indicator surface (2); the user is allowed to see the temperature value easily. The indicator (3) is preferably a seven-segment-display.

The home appliance of the present invention comprises at least one control card (K) regulating the operation of the appliance, and being connected to at least one control panel (P) which is provided in the appliance and by which the user can select and determine necessary device adjustments according to the user need. Said control card (K) comprises at least one capacitive sensor (4) which is located on the card (K) by automatic placement machine. Thanks to the capacitive sensor (4) of the invention, labor cost and an increase in the production time are prevented which are occurred due to the fact that said capacitive sensors cannot be placed on the card (K) by the automatic placement machine.

## Claims

1. A home appliance, which comprises at least one control panel (P) comprising at least one touch surface (1), and at least one control card (K) sensing and performing determined functions via said panel (P) and comprising various electronic components, **characterized by** comprising at least one capacitive sensor (4) which comprises at least one elastic filling element (4b) and at least one metal strip (4a) coated around the filling element (4b), which is positioned on said card (K), and which senses the touch when there is a touch on the touch surface (1).

2. A home appliance according to claim 1 **characterized in that** said sensor (4) is a sensor (4) which is positioned on the card (K) by means of automatic placement machine.

3. A home appliance according to claim 1 **characterized by** comprising at least one indicator (3) which is positioned on the control card (K), for indicating the operation status and/or determined functions of the appliance.

4. A home appliance according to claim 3 **characterized by** comprising at least one indicator surface (2), which is located on the control panel (P), for indicating the information shown on the indicator (3) to the user.

5. A home appliance according to claim 4 **characterized in that** the indicator surface (2) is in transparent form.

6. A home appliance according to claim 3 **characterized in that** said indicator (3) is a seven-segment-display.

7. A home appliance according to claim 1 **characterized by** comprising at least one audible alarm element which warns the user about the operation status of the appliance.

8. A home appliance according to claim 1 **characterized in that** the elastic filling element (4b) is sponge.

9. A home appliance according to claim 1 **characterized in that** the elastic filling element (4b) is rubber.

10. A home appliance according to claim 1 **characterized in that** the elastic filling element (4b) is spring.
